# EUROPEAN PATENT APPLICATION

(11) **EP 4 766 136 A2**
(43) Date of publication of application: **24.06.2026**
(21) Application number: 25225343.0
(22) Date of filing: 18.12.2025
(51) Int. Cl.: H10W 20/40, H10W 74/10, H10D 62/85, H10D 64/23

(54) **SEMICONDUCTOR DEVICE WITH A WRAPPED FINGER ELEMENT**

(30) Priority: 20.12.2024 US 202418989487
(71) Applicant: NXP USA, Inc., Austin, TX 78735 (US)
(72) Inventor: KABIR, Humayun, 5656AG Eindhoven (NL)
(74) Representative: Schwarzweller, Thomas

(57) **Abstract**

An integrated circuit device is disclosed which has a substrate layer with input and output terminals and an array of FET elements formed over a top surface of the substrate layer, where each FET element includes an elongated source contact with opposed sides extending longitudinally between a first source end that is proximate to the output terminal layer and a second source end that is proximate to the input terminal; a U-shaped drain contact positioned to enclose the first source end and located to define a U-shaped channel region between the elongated source contact and the U-shaped drain contact; and a U-shaped gate contact positioned over the U-shaped channel region and between the U-shaped drain contact and the elongated source contact, where the U-shaped gate contact and U-shaped drain contact each have a closed end located in the peripheral ancillary region between the first source end and the output terminal.

## Description

### BACKGROUND OF THE INVENTION

### Field of the Invention

The present disclosure is directed in general to the field of semiconductor devices. In one aspect, the present disclosure relates to a transistor with multiple transistor elements that are integrally formed within a single semiconductor die and processes for integrating multiple transistors elements into a single chip or integrated circuit.

### Description of the Related Art

Semiconductor-based power transistor devices are commonly used in cellular base stations to provide amplification of radio frequency (RF) signals prior to transmission of those signals over the air interface. To keep up with the requirements of emerging cellular technologies (e.g., 5G), power transistor device designers continue to develop transistors that are capable of higher and higher levels of amplification (e.g., higher gain). Conventional silicon power transistors often required larger sizes which resulted in cost increases. To improve on power performance of silicon power transistors, gallium nitride (GaN) die technology has become the technology of choice for present and future cellular application because of its high-power capability and high frequency performance. However, GaN is an expensive die material, so the ability to shrink die sizes is the key to reducing cost and staying ahead of competition in highly competitive markets. One approach for reducing die size is to shrink the source drain pitch, but this approach is limited due to increasing thermal temperatures which can impair die reliability and degrade RF performance if the pitch is reduced too aggressively. Another approach for reducing die size is to employ backside source TSV contacts in a compact die layout and to reduce the number of TSVs which occupy significant die area. An alternative approach for reducing die size is to avoid traditional layouts for large macro die with large numbers of fingers that form a long rectangular strip which can reduce potential die per wafer (PDPW) and increase die costs. A long narrow strip die reduces PDPW and increases die cost. As seen from the foregoing, the existing solutions for providing power transistors are extremely difficult at a practical level by virtue of the challenges with meeting the performance requirements and cost constraints for mass production of semiconductor devices and avoiding the performance and reliability related problems associated with conventional power transistors.

### BRIEF DESCRIPTION OF THE DRAWINGS

The present disclosure may be understood, and its numerous objects, features and advantages obtained, when the following detailed description of a preferred embodiment is considered in conjunction with the following drawings.
Figure 1 is a circuit schematic of a common source field-effect transistor (FET) device.
Figure 2 is a simplified partial cross-sectional view of a hetero-junction field effect transistor (HFET) device showing the arrangement of gate, source and drain structures in a substrate.
Figures 3A and 3B (referred to collectively herein as Figure 3) show plan and cross-sectional views of a layout of a prior art FET segment.
Figures 4A-4C (referred to collectively herein as Figure 4) show plan and cross-sectional views of a layout of an FET segment having wrapped gate and drain fingers in accordance with selected embodiments of the present disclosure.
Figure 5 is a comparative plan view of a first array of prior art FET segments and a second array of FET segments having wrapped gate and drain fingers in accordance with selected embodiments of the present disclosure.
Figure 6 is a simplified process flow chart illustrating various methods for fabricating devices in accordance with selected embodiments of the present disclosure.

### DETAILED DESCRIPTION

A method and apparatus are described for fabricating integrated circuit transistor elements on a reduced die size by forming wrapped drain and gate finger structures between a shared source region for neighboring transistor elements and an adjacent drain bond pad, thereby effectively connecting drain and gate fingers on opposed sides of the shared source region into a "U"-shaped structure. In selected embodiments, neighboring transistor elements are formed in a gallium nitride transistor die which includes a shared source region located between the input and output terminals and connected to the backside of the gallium nitride transistor die by a shared source through-substrate via (TSV). As formed, the neighboring transistor elements include first and second primary gate finger contacts which are located on opposed first and second sides of the shared source region to extend longitudinally from the output terminal toward the input terminal, where the first and second primary gate finger contacts are connected together by a wrapped gate finger contact which extends laterally between the shared source region and the output terminal to connect the first and second primary gate finger contacts. In addition, the neighboring transistor elements include first and second primary drain finger contacts which are located on opposed outer sides of the first and second primary gate finger contacts to extend longitudinally from the output terminal toward the input terminal. In addition, the neighboring transistor elements include an additional drain finger contact which is orthogonal to the first and second primary drain finger contacts to extend laterally between the ends of the first and second primary drain finger contacts which are closest to the output terminal. In selected embodiments where the additional drain finger is physically separate from the first and second primary drain finger contacts but electrically connected together, the additional drain finger and the first and second primary drain finger contacts effectively form a "U"-shaped drain structure that wraps around the shared source region with the additional drain finger positioned between the drain bond pad and the shared source region for the neighboring transistor elements. By forming the wrapped drain and gate finger structures outside of the conventional active areas located on opposed sides of the shared source region, there is no negative thermal impact on the drain and gate fingers located on opposed sides of the shared source region. In addition, the formation of wrapped drain and gate finger structures to be shared by neighboring transistor elements adds an extra transistor size at the periphery of each neighboring transistor element without using any additional die space, effectively reducing the required die size for a given unit transistor gate width measure by a significant amount (e.g., 20% reduction in die size).

Various illustrative embodiments will now be described in detail with reference to the accompanying figures. As described hereinbelow, the disclosed embodiments can be arranged and designed in a wide variety of different configurations. Thus, the following detailed description of various embodiments, as represented in the figures, is not intended to limit the scope of the present disclosure, but is merely representative of various embodiments. While various details are set forth in the following description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. In addition, the various aspects of the embodiments are presented in drawings that are not necessarily drawn to scale unless specifically indicated. Furthermore, the described features, advantages, and characteristics of the invention may be combined in any suitable manner in one or more embodiments. One skilled in the relevant art will recognize, in light of the description herein, that the embodiments can be practiced without one or more of the specific features or advantages of a particular embodiment. In other instances, additional features and advantages may be recognized in certain embodiments that may not be present in all embodiments. For example, selected aspects are depicted with reference to simplified cross sectional drawings of a semiconductor device without including every device feature or geometry in order to avoid limiting or obscuring the present invention. It is also noted that, throughout this detailed description, certain materials will be formed and removed to fabricate the semiconductor structure. Where the specific procedures for forming or removing such materials are not detailed below, conventional techniques to one skilled in the art for growing, depositing, removing or otherwise forming such layers at appropriate thicknesses shall be intended. Such details are well known and not considered necessary to teach one skilled in the art of how to make or use the present invention.

As disclosed herein, a multi-element transistor is integrally formed within a semiconductor die (a.k.a., "transistor die") which includes a semiconductor substrate with one or more transistor "segments" integrally formed and arranged in parallel in the semiconductor die. In selected embodiments, each transistor segment includes an input terminal (or portion thereof), an output terminal (or portion thereof), and a through-substrate via (TSV) positioned between the input and output terminals. In addition, each transistor segment includes transistor elements, including a channel, source and drain contacts at opposite ends of the channel, and a gate structure over the channel between the source and drain contacts. As used herein, certain transistor elements are referred to as "primary" transistor elements, and certain other transistor elements are referred to as "ancillary" transistor elements. This terminology is used for convenience only to differentiate various transistor elements, and the terminology should not be construed as limiting. As will be explained in more detail below, the ancillary transistor elements are positioned in "ancillary regions" of the semiconductor die which are located outside of the active areas of the die that conventionally include active transistor elements. By including ancillary transistor elements in these ancillary regions, the present disclosure enables significant increases in the power generating capability of the transistor die within a same physical footprint, when compared with conventional transistor layouts. Accordingly, by including ancillary transistor elements within the ancillary regions of the transistor die, the various embodiments of transistor dice disclosed herein may enable the total periphery and power of a transistor die to be increased without increasing the total die size.

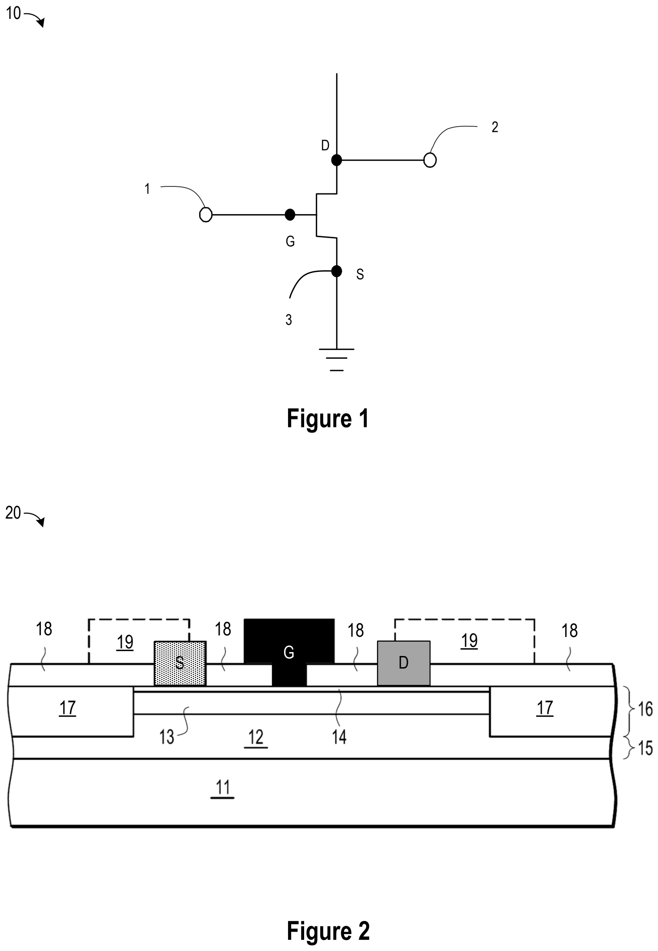

To provide additional details for an improved contextual understanding of the present disclosure, reference is now made to Figure 1 which depicts a circuit schematic of a common source field-effect transistor (FET) device 10 which is connected in a common source configuration. In the depicted common source FET device 10, the transistor gate G serves as an input port 1 and the transistor drain D serves as an output port 2. In addition, the depicted common source FET device 10 includes a transistor source S that serves as a common connection 3 that is coupled to a ground reference (i.e., the source is grounded). Thus, common source FET device 10 is an example of a two-port active device in which two of the three terminals of the FET device 10 serve as the input and output ports, and the third terminal is used as the common connection. For clarity of discussion, transistor layouts discussed herein have a common source configuration, but the following discussion applies equivalently to other two-port active device configurations in which, for example, the transistor gate may serve as the common connection or the transistor drain may serve as the common connection.

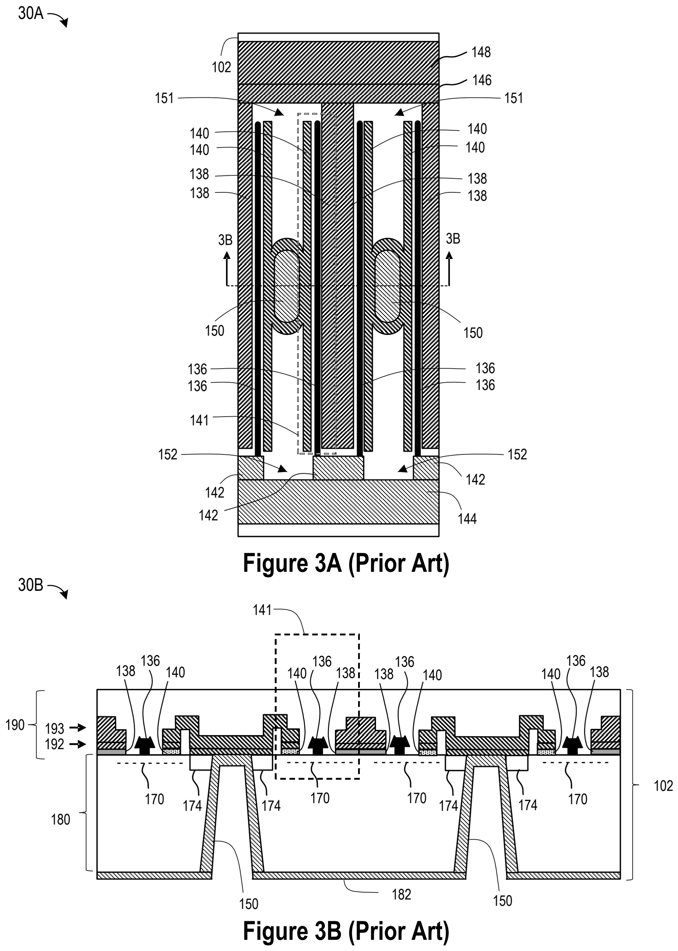

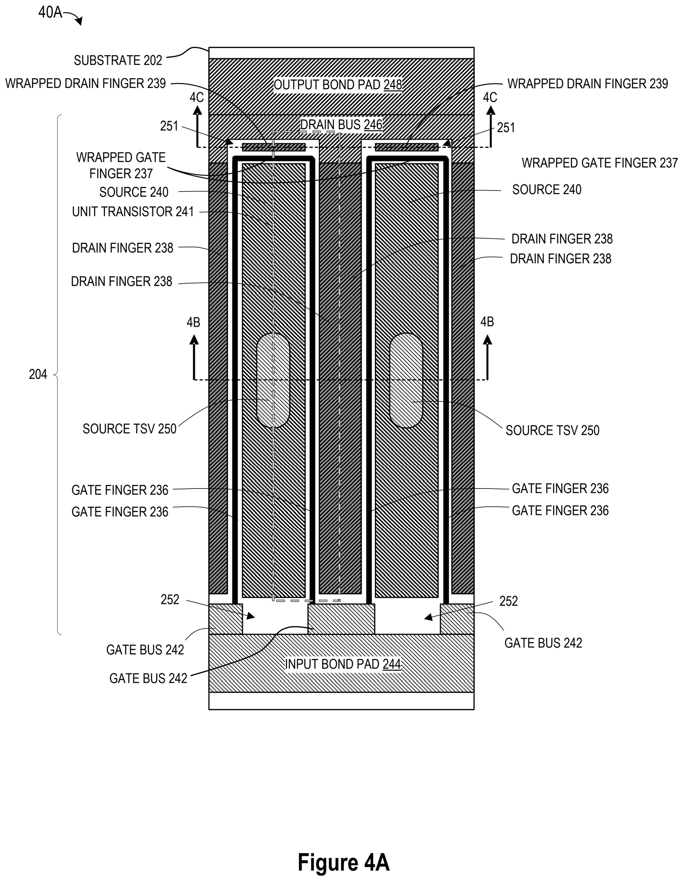

The disclosed common source FET device 10 may be implemented with one or more transistor elements that are integrated within a single semiconductor die. More particularly, one or more transistor elements, each embodying a common source FET configuration, may be implemented in parallel between input and output terminals of the semiconductor die. As will be appreciated by those skilled in the art, multiple instances of transistor segments may be implemented in parallel to achieve a desired level of amplification for the common source FET device 10. For example, Figures 3A and 4A show top or plan views of FET segments, where each FET segment includes at least two identical, side-by-side "unit transistors" (a.k.a., neighboring unit transistors). Two neighboring unit transistors are shown for each FET segment to clearly show how adjacent or neighboring unit transistors within a FET segment would be arranged. Those of skill in the art would understand, based on the description herein, that a FET segment may include one or more unit transistors, where each unit transistor includes multiple transistor structures (e.g., transistor "fingers"), where some of the transistor structures are described as "primary" structures, and others are described as "ancillary" structures. These terms are used for convenience only, and it should be understood that each primary and ancillary transistor element essentially corresponds to a transistor with a common source configuration.

The various FET segments described herein rely on electrically-conductive source TSVs to minimize common-node inductance, which may limit the high-frequency performance of the FET segment. More particularly, FET performance is enhanced by placing source TSVs within a region immediately adjacent to the gate structures. This configuration may be referred to as a "slot via" layout, in which one or more source TSVs are placed between active gate structures. The source TSVs are electrically coupled through metallization (referred to as "source metallization" herein) to source contacts, and when the transistor die is incorporated into a larger electrical system (e.g., an amplifier), the source TSVs are coupled to a ground reference node (e.g., system ground), thus establishing the common source configuration.

Applicants have determined that a need exists for improved semiconductor devices and associated fabrication processes to overcome the problems in the art, such as outlined above, though further limitations and disadvantages of conventional processes and technologies will become apparent to one of skill in the art after reviewing the remainder of the present application. For example, transistors formed with AlGaN/GaN hetero-structures enjoy high speed, high breakdown and low on-resistance because GaN has inherently high breakdown field strength and AlGaN/GaN hetero-junctions have very high electron sheet density. The high breakdown field strength and high electron sheet density arise from the relatively wide bandgap of GaN (3.4 eV) as compared to conventional semiconductor technologies such as Si (1 eV bandgap) and GaAs (1.6 eV bandgap).

To provide additional details for an improved contextual understanding of the present disclosure, reference is now made to Figure 2 which depicts a simplified partial cross-sectional view of a hetero-junction field effect transistor (HFET) device 20 showing the arrangement of gate, source and drain structures in a substrate. As depicted, the HFET device 20 is formed in a semiconductor substrate 11-14 which includes a host or base substrate layer 11 formed with an insulating layer, such as sapphire, Si, SiC, diamond, GaN, AlN and various other generally refractory materials. On the host/base substrate layer 11, a gallium nitride (GaN) buffer or channel layer 12 and undoped Al_{X}Ga_{1-X}N barrier layer 13 are sequentially formed using a desired process, such as metal-organic chemical vapor deposition (MOCVD), molecular beam epitaxy (MBE), hydride vapor phase epitaxy (HVPE) or a combination thereof. In addition, a thin GaN cap or surface termination layer 14 may also be formed on the undoped Al_{X}Ga_{1-X}N barrier layer 13.

In an active island or mesa section 16 of the semiconductor substrate 11-14, an active island or mesa 16 is formed to extend from a lower portion 15 of the GaN buffer layer 12, where the electrically inactive insulating material in isolation regions 17 outside the mesa or island 16 provides device-to-device isolation and the lower portion 16 provides a transition zone for any crystalline imperfections at the interface with the host/base substrate 11. Over the semiconductor substrate, a passivation layer 18 is formed with a dielectric material (e.g., Si₃N₄, SiO₂, SiOₓN_{y}, AlN, Al₂O₃, HfO₂). The passivation layer 18 is formed with openings for various electrodes G, S, D for the HFET device 10. In particular, the source/drain electrodes S, D make contact through openings in the passivation layer 18 to contact the channel at the GaN cap or surface termination layer 14 to thereby connect the source/drain regions to the conductive interconnections 19 for electrical coupling to various other devices or elements (not shown).

The mushroom or T-gate electrode G is formed in a gate opening of the passivation layer 18 with a short gate length contact base at the substrate surface with sidewall extensions formed directly on and adjacent to the underlying dielectric passivation layer 18. Though not shown, it will be appreciated that one or more previously--formed gate dielectric layers may be exposed by the gate opening which were previously formed on the active device island or mesa in the intended channel regions using any desired deposition sequence, though the gate dielectric layer(s) are not necessarily formed on the active device islands(s) or mesa(s). However, by forming the gate electrode G directly on the channel at the GaN cap or surface termination layer 14, a Schottky gate contact structure G is formed.

To provide additional details for an improved contextual understanding of the present disclosure, reference is now made to Figures 3A and 3B (referred to collectively herein as Figure 3) which show a plan view 30A and cross-sectional view 30B of a layout of a prior art FET segment which includes multiple transistor elements (e.g., element 141), each having a substantially identical configuration. More specifically, Figure 3A shows a top view 30A of the FET segment 30, and Figure 3B shows a cross-sectional side view 30B of the FET segment 30 of Figure 3A through line 3B-3B. Again, in a typical transistor die, multiple instances of FET segment 30 may be replicated side-by-side to build up a full-size transistor.

As disclosed, the FET segment 30 may employ a multi-layer circuit configured integrally formed within a semiconductor substrate 102. As best shown in Figure 3B, the semiconductor substrate 102 includes a base semiconductor substrate 180 (or "base substrate") and a build-up structure 190 coupled to the top surface of the base substrate 180. The build-up structure 190 includes multiple dielectric layers (not numbered) that separate multiple patterned conductive layers 192, 193, along with conductive vias (not numbered) that electrically connect portions of the conductive layers 192, 193. Portions of the conductive layers 192, 193 may be referred to as "metallization" layers (e.g., "source metallization," "drain metallization," and so on). The conductive vias may be formed from portions of the conductive layers 192, 193 that extend through openings in an underlying dielectric layer, enabling those portions of the conductive layers 192, 193 to make contact with a portion of an underlying conductive layer or conductive feature (e.g., a gate structure 136 or a drain or source contact 138, 140). Although not shown in Figure 3B, additional patterned conductive layers may overlie layers 192, 193, along with additional conductive vias (also not shown) that electrically interconnect the layers. Conductive layers 192, 193 and the aforementioned additional conductive layers provide electrical connections between structures at the surface of base substrate 180 (e.g., gate structures and drain/source contacts) and input and output terminals (e.g., input and output bond pads 144, 148) that are exposed at the top surface of the build-up structure 190. Although Figure 3 shows two conductive layers 192, 193, in other embodiments, more conductive layers may be included in the build-up structure 190.

Between the input and output bond pads 144, 148, the FET segment 30 includes a central region having multiple sets of elongated gate structures 136, drain contacts 138, and elongated source contacts 140 extending longitudinally through the central region. In particular, the depicted elongated gate structures 136 (sometimes referred to as gate fingers) (four shown) extend longitudinally across the central region from the conductive gate busses 142 toward (but without reaching) the conductive drain bus 146. In addition, the depicted elongated drain contacts 138 (sometimes referred to as drain fingers) (four shown) extend longitudinally across the central region from the conductive drain bus 146 toward (but without reaching) the conductive gate busses 142. As depicted, the two central drain contacts 138 are electrically coupled through drain metallization formed from a portion of the conductive layers 192, 193. In addition, the depicted elongated source contacts 140 (sometimes referred to as source fingers) (four shown) are formed within the build-up structure 190 to extend longitudinally across the central region between (but not reaching) the conductive drain bus 146 and the conductive gate busses 142. As used herein, the term "contact" refers to an electrically conductive feature that directly contacts the top surface of the base substrate 180 (although a contact may be recessed below the top surface, as well) proximate to a first or second end of a channel 170 within the base substrate 180. According to selected embodiments, the drain and source contacts 138, 140 may be ohmic contacts.

The depicted drain and source contacts 138, 140 are arranged in a substantially parallel configuration, with a gate structure 136 positioned between sets of adjacent drain and source contacts 138, 140. Given this arrangement, the gate structures, drain contacts, and source contacts 136, 138, 140 may be referred to as "interdigitated." Further, each arrangement of an adjacent drain contact 138, gate structure 136, and source contact 140 may be referred to herein as a "transistor element" 241. As best shown in Figure 3B, a channel 170 underlies each set of adjacent drain contacts, gate structures, and source contacts 138, 136, 140 within each transistor element 141, thus providing for current to flow through the upper channel portion 170 of the base substrate 180 between drain and source contacts 138, 140 in response to electrical signals applied to the gate structures 136. Each transistor element 141 may be electrically isolated from the source TSVs 150 with isolation regions 174 at and below the top surface of the base substrate 180.

As most clearly seen in Figure 2A, the lengths (e.g., longitudinal or vertical dimension in Figure 2A) of each of the gate structures 136 are substantially equal, and the gate structures 136 are arranged in parallel. Similarly, the lengths of each of the drain contacts 138 are substantially equal, and the drain contacts 138 are arranged in parallel. Finally, the lengths of each of the source contacts 140 also are substantially equal, and the source contacts 140 are arranged in parallel. Accordingly, each of the gate structures 136 have substantially the same configuration (e.g., length and orientation), each of the drain contacts 138 have substantially the same configuration, and each of the source contacts 140 have substantially the same configuration. On a higher level, each of the transistor elements are implemented in parallel, and have substantially the same configuration (e.g., length and orientation) as the other transistor elements in the FET segment 30.

Gate structures 136 are coupled together by one or more conductive gate busses 142, which in turn are connected to a first bond pad (or terminal), referred to herein as an input bond pad 144 (or input terminal). More specifically, the input bond pad 144 is coupled to gate busses 142 at an input side of FET segment 30. One or more conductive vias and/or portions of intermediate conductive layers may be used to electrically connect the gate busses 142 and the input bond pad 144. Similarly, drain contacts 138 are coupled together by a conductive drain bus 146, which in turn is connected to a second bond pad (or terminal), referred to herein as an output bond pad 148 (or output terminal). More specifically, the output bond pad 148 is coupled to drain bus 146 at an output side of FET segment 30. In selected embodiments, the drain bus 146 and the output bond pad 148 are formed from portions of an uppermost conductive layer, although in other embodiments, one or more conductive vias and/or portions of intermediate conductive layers may be used to electrically connect the drain bus 146 and the output bond pad 148. It should be noted that, in some embodiments, the input and output bond pads 144, 148 may be implemented as other types of conductive I/O structures that are not necessarily "bond pads" (e.g., structures suitable for attaching wirebonds), and thus structures 144, 148 should be thought of more generally as I/O terminals.

Formed through the substrate 180, one or more TSVs 150 (referred to as "source TSVs") are electrically connected to each source contact 140 through "source metallization," which includes various conductive vias and portions of conductive layers in the build-up structure 190. In the FET segment 30, each source TSV 150 is electrically coupled to two source contacts 140, one on either side of the source TSV 150. The source TSVs 150 extend through the base substrate 180 to electrically connect the source contacts 140 to a ground reference node (e.g., conductive layer 182) on a lower surface of base substrate 180. In some embodiments, the conductive material within the source TSVs 150 may be portions of the conductive layer 182 that are deposited onto the sidewalls of the opening for the TSVs 150 while conductive layer 182 is being deposited.

As shown in the plan view of Figure 3A, there are peripheral "ancillary" regions 151 located between the unit transistor elements (e.g., 141) and the conductive drain bus 146 where no structures associated with the transistor's function (e.g., gate structures, drain contacts, source contacts) are present. In addition, there are peripheral "ancillary" regions 152 located between the unit transistor elements (e.g., 141) and the conductive gate bus 142 where no structures associated with the transistor's function (e.g., gate structures, drain contacts, source contacts) are present. As shown, the peripheral ancillary regions 151, 152 do not include any TSVs 150. In some embodiments, only isolation regions 174 are present in the peripheral ancillary regions 151, 152. Alternatively, the isolation regions 174 may not be present in the peripheral ancillary regions 151, 152. Either way, no gate, drain, source, or other functional transistor structures 136, 138, 140, 141 are present in the peripheral ancillary regions 151, 152.

In accordance with the present disclosure, extra or "ancillary" transistor finger structures are included in the peripheral ancillary regions 151, 152 in order to enable a transistor to deliver higher power, when compared with a comparable transistor that does not include such ancillary transistor finger structures. In embodiments in which the source TSV is located in a central location between the input and output terminals, suitable peripheral ancillary regions may be present on both the input side and the output side of the source TSV, and ancillary transistor finger structures may be included in the input side ancillary region and/or the output side ancillary region. In other embodiments in which the source TSV is located close to the input terminal (e.g., where only one suitable peripheral ancillary region is present between the source TSV and the output terminal), ancillary transistor finger structures may be included in the output side ancillary region. In other embodiments in which the source TSV is located close to the output terminal (e.g., where only one suitable peripheral ancillary region is present between the source TSV and the input terminal), ancillary transistor finger structures may be included in the input side ancillary region. As shown in Figures 4A-4C and explained in detail hereinbelow, the ancillary transistor finger structures may be positioned orthogonally to the primary transistor finger structures and located within the peripheral ancillary region. In each of the below-described embodiments, the total periphery of the transistor device is increased without increasing total die size.

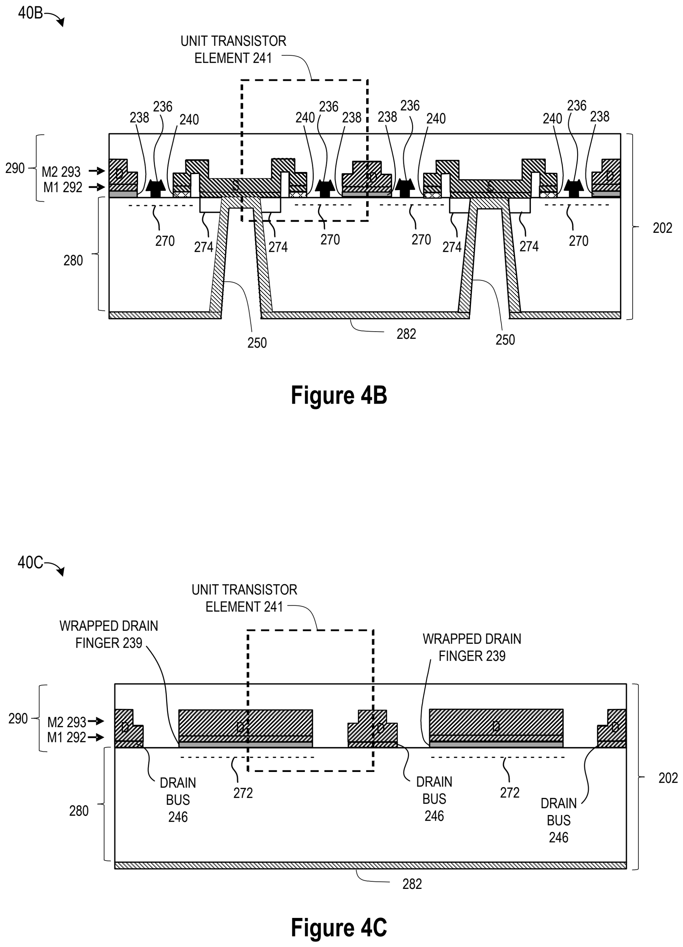

To provide additional details for an improved understanding of the present disclosure, reference is now made to Figures 4A-C (referred to collectively herein as Figure 4) which show a plan view 40A and cross-sectional view 40B, 40C of a layout of a FET segment 40 which includes multiple transistor elements (e.g., element 241), each having a substantially identical configuration with a wrapped gate finger 237 and wrapped drain finger 239 in accordance with selected embodiments of the present disclosure. More specifically, Figure 4A shows a top view 40A of the FET segment 40, Figure 4B shows a cross-sectional side view 40B of the FET segment 40 of Figure 4A through line 4B-4B, and Figure 4C shows a cross-sectional side view 40C of the FET segment 40 of Figure 4C through line 4C-4C. Again, in a typical transistor die, multiple instances of FET segment 40 may be replicated side-by-side to build up a full-size transistor.

FET segment 40 may employ a multi-layer circuit configured integrally formed within a semiconductor substrate 202. As best shown in Figures 4B-4C, the semiconductor substrate 202 includes a base semiconductor substrate 280 (or "base substrate") and a build-up structure 290 coupled to the top surface of the base substrate 280. The base semiconductor substrate 280 may be formed, for example, from bulk or composite semiconductor materials (e.g., silicon (Si), gallium nitride (GaN), gallium arsenide (GaAs), silicon-on-insulator (Sol), GaN-on-insulator (e.g., GaN on Si, GaN on silicon carbide, GaN on sapphire, and so on), or other suitable materials).

The build-up structure 290 includes multiple dielectric layers (not numbered) that separate multiple patterned conductive layers 292, 293, along with conductive vias (not numbered) that electrically connect portions of the conductive layers 292-293. Portions of the conductive layers 292-293 may be referred to as "metallization" herein (e.g., "source metallization," "drain metallization," and so on). Conductive layers 292-293 provide electrical connections between structures at the surface of base substrate 280 (e.g., gate structures and drain/source contacts) and input and output terminals (e.g., input and output bond pads 244, 248) that are exposed at the top surface of the build-up structure 290. Although Figure 4 (and more specifically Figures 4B-4) shows two conductive layers 292-293, in other embodiments, more or fewer conductive layers may be included in the build-up structure 290. In addition, although various features are illustrated within particular ones of the conductive layers 292-293, such features may be located in different layers than those depicted.

As depicted, the FET segment 40 includes an input bond pad 244 (or input terminal) proximate a first side of the die in which FET segment 40 is included, an output bond pad 248 (or output terminal) proximate an opposite, second side of the die in which FET segment 40 is included, and a central region 204 between the input and output bond pads 244, 248. It should be noted that, in some embodiments, the input and output bond pads 244, 248 may be implemented as other types of conductive I/O structures that are not necessarily "bond pads" (e.g., structures suitable for attaching wire bonds), and thus structures 244, 248 should be thought of more generally as I/O terminals.

As shown in the plan view of Figure 4A, the central region 204 includes a "primary" region in which multiple "primary" transistor elements 240/236/238 are formed, and an "ancillary" region 251 in which multiple "ancillary" transistor elements 240/237/239 are formed between the "primary" transistor elements 240/236/238 and the conductive drain bus 246. Although each of the various transistor elements essentially include the same functional transistor structures (e.g., a gate structure, drain/source contacts, and a channel), the terms "primary" and "ancillary" are used to differentiate transistor structures that are located outside of ancillary regions 251 or within ancillary regions 251. Each "primary" transistor includes a shared source region 240 and an adjacent longitudinal primary drain finger contact 238 that is spaced apart from the shared source region 240 to define a channel layer 270 which is controlled by a longitudinal primary gate finger contact 236. In addition, each "ancillary" transistor is formed with the shared source region 240 and an adjacent lateral secondary or wrapped drain finger contact 239 that is spaced apart from the shared source region 240 to define a channel layer 270 which is controlled by a lateral secondary gate finger contact 237. As formed, the longitudinal primary gate finger contacts 236 which are located on opposed outer sides of a shared source region 240 are connected together by the lateral secondary or wrapped gate finger contact 237 which extends laterally and is positioned between the shared source region 240 and the output terminal 246/248. In addition, the longitudinal primary drain finger contacts 238 which are located on opposed outer sides of a shared source region 240 are connected together by the lateral secondary or wrapped drain finger contact 239 which extends laterally and is positioned between the shared source region 240 and the output terminal 246/248. As depicted, the lateral secondary or wrapped drain finger contact 239 is physically separate from, but electrically connected to, the longitudinal primary drain finger contacts 238. In this way, the longitudinal primary drain finger contacts 238 and the lateral secondary or wrapped drain finger contact 239 effectively form a "U"-shaped drain structure that wraps around the shared source region 240.

As depicted, one or more source TSVs 250 are positioned within the central region 204 between the input and output terminals 244, 248. The source TSVs 250 are electrically connected to each source contact 240 through "source metallization," which includes various conductive vias and portions of conductive layers in the build-up structure 290. In the FET segment 40, each source TSVs 250 is electrically coupled to a shared source contact 240. As depicted, the source TSV 250 may have a circular or oval shape, but any suitable shape may be used. In addition, the shared source region 240 is shown as a rectangular shape that overlaps with the source TSV 250 and extends longitudinally between (but without reaching) the input and output terminals 246, 244. As shown in Figure 4B, the source TSVs 250 extend through the base substrate 280 and serve to electrically connect the source contacts 240 to a ground reference node (e.g., conductive layer 282) on a lower surface of base substrate 280.

Associated with each source TSV 250, a first "output side" ancillary region 251 is present on the output side (i.e., between the source TSV 250 and the output bond pad 248), and a second "input side" ancillary region 252 is present on the input side (i.e., between the source TSV 250 and the input bond pad 244). In selected embodiments, either or both of the ancillary regions 251, 252 may be used to form ancillary transistor elements, depending on the location of the source TSV 250 in proximity to the input bond pad 244 or the output bond pad 248.

The primary transistor fingers will be defined first. Essentially, the primary transistor fingers are composed of a plurality of elongated primary gate structures 236 (or gate fingers) (four shown) and elongated primary drain contacts 238 (or drain fingers) (four shown) disposed on opposed sides of the elongated source contacts 240 (or source fingers) (two shown) formed within the build-up structure 290. Again, as used herein, the term "contact" refers to an electrically conductive feature that directly contacts the top surface of the base substrate 280 (although a contact may be recessed below the top surface, as well) proximate to a first or second end of a channel 270 within the base substrate 280. In selected embodiments, the drain and source contacts 238, 240 may be ohmic contacts. To assist with clarity, the source contact 240 is shown in cross-hatched elements, and the source metallization formed over the source contact 240 is depicted with diagonal-hatched elements (upper left to lower right). In addition, the drain contact 238 is shown with gray shading, and the drain metallization formed over the drain contact 238 is depicted with diagonal-hatched elements (lower left to upper right).

The primary drain and source contacts 238, 240 are arranged in a substantially parallel configuration, with a primary gate structure 236 positioned between and oriented in parallel with the set of adjacent primary drain and source contacts 238, 240, thus defining a "primary transistor finger" or a "primary transistor element" (e.g., primary transistor finger/element 241). Given this arrangement, the primary gate structures, primary drain contacts, and source contacts 236, 238, 240 may be referred to as "interdigitated." On each side of a shared source region 240, the primary gate structures, primary drain contacts, and source contacts 236, 238, 240 form a unit transistor element (e.g., 241). Further, each primary unit transistor element 241 is configured so that, during operation, current from the primary source contact 240 to the primary drain contact 238 flows in a first direction through the channel 270 (e.g., a horizontal direction in the orientation of Figure 4A).

As shown in Figure 4A, the primary gate structures 236 are coupled together by one or more conductive primary gate busses 242, which in turn are connected to the input bond pad 244. More specifically, the input bond pad 244 is coupled to primary gate busses 242 at an input side of FET segment 40. One or more conductive vias and/or portions of intermediate conductive layers may be used to electrically connect the primary gate busses 242 and the input bond pad 244. Similarly, the primary drain contacts 238 are coupled together by a conductive drain bus 246, which in turn is connected to the output bond pad 248. More specifically, the output bond pad 248 is coupled to drain bus 246 at an output side of FET segment 40. In selected embodiments, the drain bus 246 and the output bond pad 248 are formed from portions of an uppermost conductive layer 293, although in other embodiments, one or more conductive vias and/or portions of intermediate conductive layers may be used to electrically connect the drain bus 246 and the output bond pad 248.

The peripheral ancillary transistor fingers will now be defined. As indicated above, the ancillary transistor fingers may be located within either or both of the ancillary regions 251, 252, whereas the primary transistor fingers are located outside of the ancillary regions 251, 252. As disclosed, the ancillary transistor fingers are composed of a plurality of lateral secondary or wrapped gate structures 237 (or gate fingers) (two shown) and lateral secondary or wrapped drain contacts 239 (or drain fingers) (two shown) disposed on at least one side (e.g., the output side) of the elongated source contacts 240 (or source fingers) (two shown) formed within the build-up structure 290. In the depicted example, the peripheral ancillary transistor fingers are formed om the ancillary region 251 between the shared source region 240 and the drain bus 246. While Figure 4 shows that each shared source 240 may be shared between the primary and ancillary transistor fingers, it will be appreciated that distinct source contacts may be included for the primary and ancillary transistor fingers.

The ancillary wrapped gate structures 237 and lateral secondary or wrapped drain contacts 239 are arranged to extend laterally in an orthogonal direction to the primary gate finger and drain contacts which extend longitudinally between the output terminal and input terminal. Further, each arrangement of an adjacent ancillary wrapped drain contact 239, ancillary wrapped gate structure 237, and shared source contact 240 may be referred to herein as an "ancillary transistor finger" or an "ancillary transistor element" component of the unit transistor element 241. Each ancillary transistor finger/element 240/237/239 is configured so that, during operation, current from the shared source contact 240 to the ancillary wrapped drain contact 239 flows in a second direction that is orthogonal to the first direction of current flow within the primary transistor finger/element (e.g., a vertical direction in the orientation of Figure 4A). In other words, the primary and ancillary transistor fingers/elements of the unit transistor 241 support current flow through the channel 270 in orthogonal directions.

As depicted, the primary and ancillary wrapped gate structures 236, 237 are arranged orthogonally to one another, with the ancillary wrapped gate structure 237 positioned in the ancillary region 251 connecting the primary gate structures 236 on opposed sides of the shared source region 240, which in turn are connected to the input bond pad 244. More specifically, the input bond pad 244 is coupled over the primary gate structures 236 to the gate busses 242 at an input side of FET segment 40.

In similar fashion, the primary and ancillary wrapped drain finger contacts 238, 239 are arranged orthogonally to one another, with the ancillary wrapped drain finger contacts 239 positioned in the ancillary regions 251 extending between (but not physically contacting) the primary drain finger contacts 238 on opposed sides of the shared source region 240. Further, each of the primary and ancillary wrapped drain finger contacts 238, 239 are electrically coupled over patterned metallization layers 292, 293 to the output bond pad 248. More specifically, the output bond pad 248 is connected over the drain busses 246 to the primary and ancillary wrapped drain finger contacts 238, 239 at an output side of FET segment 40.

As shown in Figure 4B, a channel 270 underlies each set of adjacent primary drain contacts, primary gate structures, and source contacts 238, 236, 240 within each primary transistor element 241, thus providing for current to flow through the upper portion of the base substrate 280 between primary drain and source contacts 238, 240 in response to electrical signals applied to the input bond pad 244 and the primary gate structures 236. More particularly, during operation of a transistor die that includes one or more instances of FET segment 40, current flow through the primary transistor fingers is in a first direction (i.e., a horizontal direction in Figure 4A). More particularly, referring to Figures 4A-4B, source current flows from the ground reference node (e.g., conductive layer 282 on the bottom of the substrate 202) through the shared source TSV 250, through source metallization (not shown) in the build-up structure 290 to the source contacts 240, through the channels 270 in response to input signals received at the input bond pad 244/gate structures 236, and through the primary drain contacts 238 and any drain metallization (not shown) to the output bond pad 248.

Similarly, Figure 4C shows that a channel 272 underlies each set of adjacent ancillary wrapped drain finger contacts 239 within an ancillary transistor element, and extends under the ancillary wrapped gate structure 236 to the shared source region 240, thus providing for current to flow through the upper portion of the base substrate 280 between ancillary wrapped drain finger and shared source region 239, 240 in response to electrical signals applied to the ancillary wrapped gate structure 237. More particularly, during operation of a transistor die that includes one or more instances of FET segment 40, current also flows through the ancillary transistor fingers in the second direction (i.e., a vertical direction in Figure 4A). More particularly, referring to Figures 4A and 4C, source current flows from the ground reference node (e.g., conductive layer 282 on the bottom of the substrate 202) through the source TSV 250, through source metallization (not shown) in the build-up structure 290 to the source contacts 240, through the channels 272 in response to input signals received at the input bond pad 244/gate structures 237, and through the ancillary wrapped drain contacts 339 and any drain metallization (not all of which is shown) to the output bond pad 248. As indicated by the above description, it is apparent that the direction of current flow through the primary transistor elements is orthogonal with the direction of current flow through the ancillary transistor elements. Each transistor element may be electrically isolated from the source TSVs 250 with isolation regions 274 at and below the top surface of the base substrate 280.

As most clearly seen in Figure 4A, the lengths (vertical dimension in Figure 4A) of each of the primary gate structures 236 are substantially equal to each other. The output side ancillary wrapped gate structures 237 also have substantially equal lengths as each other, and the output side ancillary wrapped drain figures 239 also have substantially equal lengths as each other, although the lengths of the ancillary wrapped gate structures 237 and ancillary wrapped drain figures 239 are substantially shorter (e.g., half or less) than the lengths of the primary gate structures 236 and primary drain fingers 238. In addition, the lengths (vertical dimension in Figure 4A) of each of the shared source regions 240 also are substantially equal and are arranged in parallel. However, as indicated above, there is a gap between input bond pad/bus 244/242 and the output bond pad/bus 248, 246 which defines peripheral ancillary regions where the ancillary transistor elements may be inserted without increasing the die size of the integrated circuit.

According to selected embodiments, during operation of a transistor die that includes one or more instances of FET segment 40, both the primary and ancillary transistor elements contribute to the total power provided by the transistor die. Essentially, the ancillary transistor elements add to the power provided by the primary transistor elements. Desirably, the ancillary transistor elements have lengths that are maximized within the peripheral ancillary regions 351, 352 in order to maximize the amount of power contributed by the ancillary transistor elements (i.e., the length of the ancillary transistor elements 237, 239 is only slightly smaller than the lengths (horizontal dimension in Figure 4A) of the ancillary regions 251, 252). As depicted, Figure 4A shows four ancillary transistor elements within the peripheral ancillary region 251, with two ancillary transistor elements connected to the shared source region 240 on the left side, and two ancillary transistor elements connected to the shared source region 240 on the right side. However, it will be appreciated that each peripheral ancillary region 351, 352 may include only one ancillary transistor element, or may include more than two ancillary transistor elements.

Referring to Figure 4A, the wrapped drain finger 239 is depicted as being disconnected from the drain bus 246 and output bond pad 248 in the sense that there is no connection shown in the plan view 40A between the drain bus 246 and wrapped drain finger 239. However, it will be appreciated that one or more patterned metallization layers 292, 293 (Figure 4C) may define an electrical connection between the drain bus 246 and wrapped drain finger 239. With reference to the plan view 40A shown in Figure 4A, one or more of the patterned metallization layers 292, 293 may extend horizontally from the left and/or right sides of the wrapped drain finger 239 to make electrical connection to the drain bus 246. In other embodiments, the one or more of the patterned metallization layers 292, 293 may extend vertically from the upper side of the wrapped drain finger 239 to make electrical connection to the drain bus 246. In such embodiments, the wrapped drain finger 239 and drain bus 246 will be merged for improved compactness.

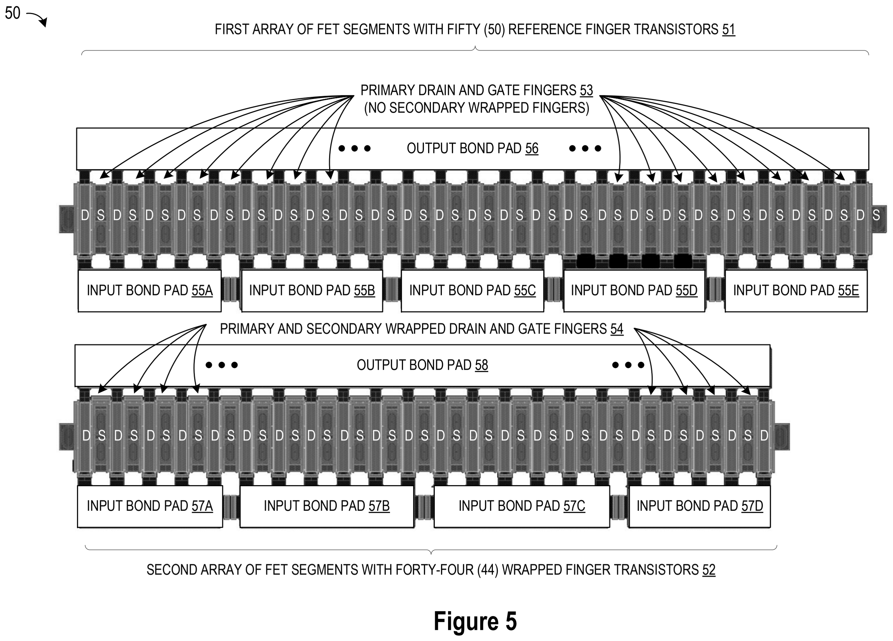

In order to build a power transistor of a desired power capability, multiple instances of the transistor units 141, 241 within FET segments 30, 40 may be replicated in parallel and interconnected with common input and output bond pads. However, the inclusion of a wrapped gate and drain fingers in the peripheral ancillary region 251 can significantly reduce the die size while retaining the same power capability of the overall power transistor. To illustrate the reduction in die size advantage, reference is now made to Figure 5 which depicts a comparative plan view 50 of a first array of FET segments 51 formed with primary drain and gate fingers 53 and a second array of FET segments 52 formed with primary and wrapped gate and drain fingers 54. In the depicted example, the first array 51 includes fifty (50) reference finger transistors formed with primary drain and gate fingers 53 on opposed sides of the shared source regions (S) (but without any wrapped drain and gate fingers). In addition, the second array 52 includes forty-four (44) finger transistors formed with primary and secondary wrapped drain and gate fingers 54. In the example where the primary drain and gate fingers in both arrays 51, 52 have the same uniform gate width (e.g., UGW = 290 um) and source-drain pitch (e.g., SDP = 67.5 um), six of the reference finger transistors from the first array 51 are replaced by the secondary wrapped drain and gate fingers of the second array 52. As a result, the second array 52 uses 44 wrapped finger transistors to replace the 50 reference finger transistors of the first array. In the first array 51, the primary transistors are connected between five (5) input bond pads 55A-E and an output bond pad 56, while in the second array 52, the primary and secondary transistors are connected between four (4) input bond pads 57A-D and an output bond pad 58, thus eliminating one bond pad. With the second array 52 requiring 2.28 mm² die size for the 44 wrapped finger transistors and the first array requiring 2.6 mm² die size for the 50 reference finger transistors, the second array of wrapped finger devices 52 reduces die size by 12%. And the shrinkage savings will be greater for shorter UGW die.

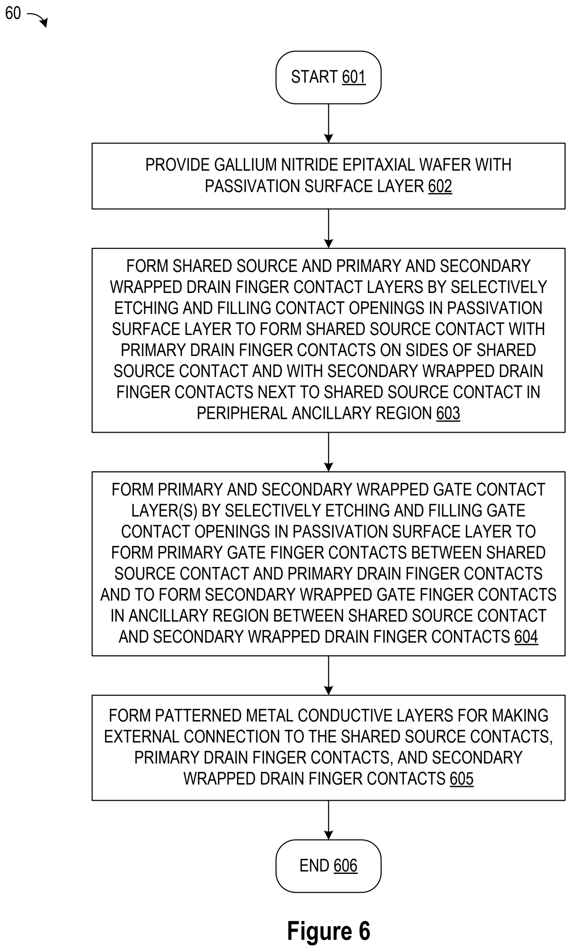

To further illustrated selected embodiments of the present invention, reference is now made to Figure 6 which is a simplified process flow chart 60 illustrating various methods for fabricating integrated circuit devices which include wrapped gate and drain finger elements in the peripheral ancillary region of the integrated circuit device. In describing the fabrication methodology 60, the description is intended merely to facilitate understanding of various exemplary embodiments and not by way of limitation. Unless otherwise indicated, subsequent steps may be provided in any desired order.

Once the fabrication methodology starts (step 601), a gallium nitride wafer substrate layer is provided at step 602. In selected embodiments, the gallium nitride wafer substrate layer may include a gallium nitride epitaxial layer formed on a silicon carbide layer and covered by an undoped Al_{X}Ga_{1-X}N barrier layer and thin GaN cap or surface termination layer using means well known in the art, though other substrate materials may instead be used. In addition, a passivation surface layer is formed to cover the gallium nitride wafer substrate layer using any suitable means. To facilitate the formation of the gate finger electrodes, the passivation surface layer may be formed as a stack of insulator layers. For example, the passivation surface layer may be formed by sequentially depositing a first thin (e.g., 50-500 nm) layer of aluminum oxide, a second thin (e.g., 50-500 nm) layer of LPCVD SiN, and a third thin (e.g., 50-500 nm) layer of aluminum oxide, though any desired insulating or dielectric material (e.g., SiO₂, SiOₓN_{y}, AlN, Al₂O₃) and deposition technique (e.g., conformal CVD, PECVD, PVD, ALD, HWCVD, CAT-CVD, ECR-CVD, ICP-CVD, evaporation, sputtering, etc.) could be used for the stacked layers, provided that exposed portions of the first and third layer can be anisotropically etched without also etching the second layer. In selected embodiments, the passivation surface layer stack includes one or more layers formed with a material that is selected to protect the substrate against gate etch damage and/or reduce leakage current in the finally formed device, such as by depositing an aluminum oxide etch stop layer on the substrate and then depositing a silicon nitride film having a low hydrogen content (e.g., <10%) to prevent a leakage current path from forming at the passivation surface layer stack and substrate surface. On the substrate, alignment marks may be formed using a Ti-Pt or other suitable material to provide suitable electron diffraction for e-beam alignment. In addition, isolation regions may be implanted using a photoresist implant mask which is subsequently stripped.

At step 603, shared source and primary and secondary wrapped drain finger contact layers are formed by selectively etching and filling contact openings in the passivation surface layer to form shared source contacts with primary drain finger contacts on opposed sides of each shared source contact and with secondary wrapped drain finger contacts next to the shared source contact in the peripheral ancillary region. In selected embodiments, the processing step 603 may be implemented by forming a first patterned etch mask layer over the passivation surface layer to selectively etch contact openings in the passivation surface layer in which the shared source contacts, primary drain finger contacts, and secondary wrapped drain finger contacts are formed. For example, a patterned photoresist mask may be formed with etch contact openings which expose the passivation surface layer in the intended source/drain contact regions, followed by application of an anisotropic silicon nitride etch to remove the exposed regions of the passivation surface layer. Following one or more ohmic contact etch steps, ohmic metal is deposited and lifted off, leaving the shared source contacts, primary drain finger contacts, and secondary wrapped drain finger contacts.

At step 604, primary and secondary wrapped gate contact layer(s) are formed by selectively etching and filling gate contact openings in the passivation surface layer to form primary gate finger contacts between the shared source contact and primary drain finger contacts, and to form secondary wrapped gate finger contacts in the ancillary region between the shared source contact and secondary wrapped drain finger contacts. In selected embodiments, the processing step 604 may be implemented by forming the passivation surface layer as a stack of insulating passivation layers which can be selectively etched with one or more patterned resist layers to selectively etch one or more stepped gate contact openings in the stack of insulating passivation layers in which the primary and secondary gate finger contacts are formed. For example, a patterned tri-layer e-beam resist mask may be formed with gate contact etch openings which expose the stack of insulating passivation layers around the intended primary and secondary wrapped gate contact layers, followed by application of a wet etch chemistry to remove the exposed top passivation layer, followed by application of low power dry reactive ion etch to remove the exposed regions of the lower passivation layer(s) with a smaller gate contact etch opening which exposes the gallium nitride epitaxial wafer layer, thereby completing the stepped gate contact opening in the passivation surface layer stack. Subsequently, a Schottky gate electrode is formed in the stepped gate contact openings to form the primary and secondary wrapped gate contact layers. For example, one or more gate metal layers may be evaporated on the patterned multi-layer resist stack to form a mushroom or T-shaped Schottky gate electrode in the stepped gate contact openings. Subsequently, a lift-off process is applied to remove the gate metal layer(s) when the patterned multi-layer resist stack is removed (e.g., by standard resist strip solvent), leaving the Schottky gate electrode. As formed, the Schottky gate electrode includes lower gate ledges upper lateral extensions or wings which may extend over the underlying passivation surface layer.

At step 605, patterned metal conductive layers are formed for making external connection to the shared source contact, primary drain finger contacts, and secondary wrapped drain finger contacts. In selected embodiments, the processing step 605 may be implemented by forming a second patterned mask layer with etch openings exposing the shared source contact, primary drain finger contacts, and secondary wrapped drain finger contacts. To this end, a patterned photoresist mask may be formed with etch openings which expose the shared source contact, primary drain finger contacts, and secondary wrapped drain finger contacts. Subsequently, the patterned metal conductive layers may be formed with a lift-off process wherein a first metal layer is deposited on the second patterned mask layer and in the etch openings so that, when the second patterned mask layer removed (e.g., by standard resist strip solvent), the patterned metal conductive layers remain to provide external connection to the shared source contact, primary drain finger contacts, and secondary wrapped drain finger contacts. At step 606, the process ends.

By now, it should be appreciated that there has been provided an integrated circuit device and associated method of fabrication. As disclosed, the integrated circuit device includes a semiconductor substrate layer having a top surface and an opposed bottom surface. In selected embodiments, the semiconductor substrate layer includes a gallium nitride substrate layer. In addition, the integrated circuit device includes a conductive input terminal formed over the top surface of the semiconductor substrate layer. In selected embodiments, the conductive input terminal includes one or more conductive input terminal layers formed over the top surface of the semiconductor substrate layer to connect each U-shaped gate contact in the array of one or more FET elements to a shared input bond pad. In selected embodiments, the array of FET elements may be a plurality of FET elements positioned in the semiconductor substrate layer and arranged in parallel between the conductive input terminal and conductive output terminal. The integrated circuit device also includes a conductive output terminal formed over the top surface of the semiconductor substrate layer. In selected embodiments, the conductive output terminal is formed with one or more conductive output terminal layers formed over the top surface of the semiconductor substrate layer to connect each U-shaped drain contact in the array of one or more FET elements to a shared output bond pad. In addition, the integrated circuit device includes an array of one or more field effect transistor (FET) elements formed on the top surface of the semiconductor substrate layer to be connected between the conductive input terminal and the conductive output terminal. As disclosed, each FET element includes an elongated source contact with first and second opposed sides extending longitudinally between a first source end that is proximate to the conductive output terminal and a second source end that is proximate to the conductive input terminal. In addition, each FET element includes a U-shaped drain contact positioned to enclose the first source end and located to define a U-shaped channel region between the elongated source contact and the U-shaped drain contact, where the U-shaped drain contact has a closed end located in a peripheral ancillary region between the first source end and the conductive output terminal. In selected embodiments, the U-shaped drain contact includes (1) first and second primary drain finger contacts which are positioned to extend longitudinally down the first and second opposed sides of the elongated source contact, and (2) a wrapped drain finger contact which is positioned adjacent to the first source end to extend laterally between terminal ends of the first and second primary drain finger contacts. In addition, each FET element includes a U-shaped gate contact positioned over the U-shaped channel region and between the U-shaped drain contact and the elongated source contact, where the U-shaped gate contact has a closed end located in the peripheral ancillary region between the first source end and the conductive output terminal. In selected embodiments, the U-shaped gate contact includes (1) first and second primary gate finger contacts which are positioned to extend longitudinally down the first and second opposed sides of the elongated source contact to be located between the elongated source contact and the first and second primary drain finger contacts, and (2) a wrapped gate finger contact which is located in the peripheral ancillary region between the first source end and the wrapped drain finger contact. In selected embodiments, the U-shaped gate contact is a Schottky gate contact structure. In selected embodiments, the integrated circuit device may also include a conductive source through-substrate via (TSV) formed in the semiconductor substrate layer to extend between the top surface and the opposed bottom surface, where the conducive source TSV is electrically coupled to make electrical contact with the elongated source contact. In selected embodiments, the conductive input terminal is electrically coupled to the U-shaped gate contact in each FET element, the conductive output terminal is electrically coupled to the U-shaped drain contact in each FET element, and the elongated source contact is electrically coupled to a ground reference voltage. In other selected embodiments, the integrated circuit device may also include one or more drain metallization layers electrically coupling the U-shaped drain contact in each FET element to the conductive output terminal, one or more gate metallization layers electrically coupling the U-shaped gate contact in each FET element to the conductive input terminal, and one or more source metallization layers electrically coupling the elongated source contact in each FET element to a ground reference voltage. In other selected embodiments, there is no overlap or crossing of the U-shaped drain contact and the U-shaped gate contact in the semiconductor substrate layer. In other selected embodiments, the U-shaped drain contact is formed with the closed end of the U-shaped drain contact and first and second primary drain contacts which are positioned to extend longitudinally down the first and second opposed sides of the elongated source contact, where the closed end is physically separate from first and second primary drain contacts and is electrically coupled to the first and second primary drain contacts over one or more drain metallization layers.

In another form, there is provided a transistor die and associated method of fabrication. As disclosed, the transistor die includes a semiconductor substrate. In addition, the transistor die includes an input terminal and an output terminal which are integrally formed over the semiconductor substrate. The transistor die also includes a source through-substrate via (TSV) integrally formed in the semiconductor substrate and positioned between the input and output terminals. In addition, the transistor die includes a shared source contact integrally formed on the semiconductor substrate and electrically coupled to the source TSV with first side and an opposed second side extending longitudinally between the output terminal and the input terminal. The transistor die also includes a peripheral ancillary region of the semiconductor substrate located adjacent to the shared source contact and positioned between the shared source contact and the output terminal. In addition, the transistor die includes first and second primary drain finger contacts integrally formed on the semiconductor substrate and electrically coupled to the output terminal, wherein the first primary drain finger contact extends from the output terminal toward the input terminal past the first side of the shared source contact and wherein the second primary drain finger contact extends from the output terminal toward the input terminal past the first side of the shared source contact. The transistor die also includes a wrapped drain finger contact integrally formed on the semiconductor substrate and electrically coupled to the output terminal, wherein the wrapped drain finger contact is positioned in the peripheral ancillary region to extend laterally between terminal ends of the first and second primary drain finger contacts. Thus formed, the transistor die includes a primary transistor element which includes the first and second primary drain finger contacts, a first portion of the shared source contact, and a primary gate structure located outside of the peripheral ancillary region. In addition, the transistor die includes an ancillary transistor element which includes the wrapped drain finger contact, a second portion of the shared source contact, and an ancillary gate structure located within the peripheral ancillary region. In selected embodiments, the primary transistor element is configured so that, during operation, current from the first portion of the shared source contact to the first and second primary drain finger contacts in a first direction, and wherein the ancillary transistor element is configured so that, during operation, current from the second portion of the shared source contact to the wrapped drain finger contact also flows in a second direction that is orthogonal to the first direction. In other selected embodiments, the primary gate structure may include first and second primary gate finger contacts integrally formed on the semiconductor substrate and positioned, respectively, between the first and second primary drain finger contacts and the first and second sides of the shared source contact, wherein the first primary gate finger contact is positioned between the first side of the shared source contact and the first primary drain finger, and wherein the second primary gate finger contact is positioned between the second side of the shared source contact and the second primary drain finger. In addition, the ancillary gate structure may include a wrapped gate finger contact integrally formed on the semiconductor substrate and positioned in the peripheral ancillary region to extend laterally between terminal ends of the first and second primary gate finger contacts. In selected embodiments, the input terminal is electrically coupled to the primary and ancillary gate structures, where the output terminal is electrically coupled to the first and second primary drain finger contacts and the wrapped drain finger contact, and where the shared source contact is electrically coupled to a ground reference voltage.

In yet another form, there is provided a semiconductor device and associated method of fabrication. As disclosed, the disclosed semiconductor device fabrication process includes providing a gallium nitride substrate. In addition, one or more passivation layers are formed on the gallium nitride substrate. In addition, the one or more passivation layers are selectively etched to define an elongated source contact opening, a U-shaped drain contact opening, and a U-shaped gate contact opening which expose the gallium nitride substrate. In addition, one or more metal layers are selectively deposited into the elongated source contact opening, the U-shaped drain contact opening, and the U-shaped gate contact opening to form source, drain, and gate contacts. In particular, an elongated source contact is formed with first and second opposed sides extending longitudinally between a first source end that is proximate to an output terminal layer and a second source end that is proximate to an input terminal. In addition, a U-shaped drain contact is formed that is positioned to enclose the first source end and located to define a U-shaped channel region in the gallium nitride substrate between the elongated source contact and the U-shaped drain contact, where the U-shaped drain contact has a closed end located in a peripheral ancillary region between the first source end and the output terminal. In addition, a U-shaped gate contact is formed that is positioned over the U-shaped channel region and between the U-shaped drain contact and the elongated source contact, where the U-shaped gate contact has a closed end located in the peripheral ancillary region between the first source end and the output terminal.

Although the described exemplary embodiments disclosed herein are directed to various fabrication processes and integrated circuit designs having ancillary transistor structures employing gate and drain fingers formed in the peripheral ancillary region between the shared source regions and drain output pads, the present disclosure is not necessarily limited to the example embodiments which illustrate inventive aspects of the present invention that are applicable to a wide variety of device fabrication processes and/or structures. Thus, the particular embodiments disclosed above are illustrative only and should not be taken as limitations upon the present invention, as the invention may be modified and practiced in different but equivalent manners apparent to those skilled in the art having the benefit of the teachings herein. For example, while the various devices are illustrated herein with reference to wrapped gate and drain fingers formed in the peripheral ancillary region between the shared source regions and drain output pads, this is merely for convenience of explanation and not intended to be limiting and persons of skill in the art will understand that the principles taught herein apply to devices with other circuit layouts. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the invention in its broadest form.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that includes a list of elements is not necessarily limited to those elements, but may include other elements not expressly listed or inherent to such process, method, article, or apparatus. The term "coupled," as used herein, is defined as directly or indirectly connected in an electrical or non-electrical manner.

As used herein, the term "semiconductor" is intended to include any semiconductor whether single crystal, poly-crystalline or amorphous and to include type IV semiconductors, non-type IV semiconductors, compound semiconductors as well as organic and inorganic semiconductors. Further, the terms "substrate" and "semiconductor substrate" are intended to include single crystal structures, polycrystalline structures, amorphous structures, thin film structures, layered structures (e.g., semiconductor-on-insulator (SOI) structures), and combinations thereof. For convenience of explanation and not intended to be limiting, semiconductor components and methods of fabrication are described herein for silicon semiconductors but persons of skill in the art will understand that other semiconductor materials may also be used.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. An integrated circuit device, comprising:
a semiconductor substrate layer having a top surface and an opposed bottom surface;
a conductive input terminal formed over the top surface of the semiconductor substrate layer;
a conductive output terminal formed over the top surface of the semiconductor substrate layer; and
an array of one or more field effect transistor, FET, elements formed on the top surface of the semiconductor substrate layer to be connected between the conductive input terminal and the conductive output terminal, where each FET element comprises:
an elongated source contact with first and second opposed sides extending longitudinally between a first source end that is proximate to the conductive output terminal and a second source end that is proximate to the conductive input terminal;
a U-shaped drain contact positioned to enclose the first source end and located to define a U-shaped channel region between the elongated source contact and the U-shaped drain contact, where the U-shaped drain contact has a closed end located in a peripheral ancillary region between the first source end and the conductive output terminal; and
a U-shaped gate contact positioned over the U-shaped channel region and between the U-shaped drain contact and the elongated source contact, where the U-shaped gate contact has a closed end located in the peripheral ancillary region between the first source end and the conductive output terminal.

2. The integrated circuit device of claim 1, where the semiconductor substrate layer comprises a gallium nitride substrate layer.

3. The integrated circuit device of claim 1 or 2, where the conductive output terminal comprises one or more conductive output terminal layers formed over the top surface of the semiconductor substrate layer to connect each U-shaped drain contact in the array of one or more FET elements to a shared output bond pad.

4. The integrated circuit device of any preceding claim, where the conductive input terminal comprises one or more conductive input terminal layers formed over the top surface of the semiconductor substrate layer to connect each U-shaped gate contact in the array of one or more FET elements to a shared input bond pad.

5. The integrated circuit device of any preceding claim, where the U-shaped drain contact comprises:
first and second primary drain finger contacts which are positioned to extend longitudinally down the first and second opposed sides of the elongated source contact, and
a wrapped drain finger contact which is positioned adjacent to the first source end to extend laterally between terminal ends of the first and second primary drain finger contacts.

6. The integrated circuit device of claim 5, where the U-shaped gate contact comprises:
first and second primary gate finger contacts which are positioned to extend longitudinally down the first and second opposed sides of the elongated source contact to be located between the elongated source contact and the first and second primary drain finger contacts, and
a wrapped gate finger contact which is located in the peripheral ancillary region between the first source end and the wrapped drain finger contact.

7. The integrated circuit device of any preceding claim, further comprising a conductive source through-substrate via (TSV) formed in the semiconductor substrate layer to extend between the top surface and the opposed bottom surface, where the conducive source TSV is electrically coupled to make electrical contact with the elongated source contact.

8. The integrated circuit device of any preceding claim, where the conductive input terminal is electrically coupled to the U-shaped gate contact in each FET element, where the conductive output terminal is electrically coupled to the U-shaped drain contact in each FET element, and where the elongated source contact is electrically coupled to a ground reference voltage.

9. The integrated circuit device of any preceding claim, further comprising one or more drain metallization layers electrically coupling the U-shaped drain contact in each FET element to the conductive output terminal.

10. The integrated circuit device of any preceding claim, further comprising one or more gate metallization layers electrically coupling the U-shaped gate contact in each FET element to the conductive input terminal.

11. The integrated circuit device of any preceding claim, further comprising one or more source metallization layers electrically coupling the elongated source contact in each FET element to a ground reference voltage.

12. The integrated circuit device of any preceding claim, where the array of FET elements comprises a plurality of FET elements positioned in the semiconductor substrate layer and arranged in parallel between the conductive input terminal and conductive output terminal.

13. The integrated circuit device of any preceding claim, where there is no overlap or crossing of the U-shaped drain contact and the U-shaped gate contact in the semiconductor substrate layer.

14. The integrated circuit device of any preceding claim, where the U-shaped drain contact comprises the closed end of the U-shaped drain contact and first and second primary drain contacts which are positioned to extend longitudinally down the first and second opposed sides of the elongated source contact, where the closed end is physically separate from first and second primary drain contacts and is electrically coupled to the first and second primary drain contacts over one or more drain metallization layers.

15. A method of forming a semiconductor device, comprising:
providing a gallium nitride substrate;
forming one or more passivation layers on the gallium nitride substrate;
selectively etching the one or more passivation layers to define an elongated source contact opening, a U-shaped drain contact opening, and a U-shaped gate contact opening which expose the gallium nitride substrate;
selectively depositing one or more metal layers into the elongated source contact opening, the U-shaped drain contact opening, and the U-shaped gate contact opening, thereby respectively forming:
an elongated source contact with first and second opposed sides extending longitudinally between a first source end that is proximate to an output terminal layer and a second source end that is proximate to an input terminal;
a U-shaped drain contact positioned to enclose the first source end and located to define a U-shaped channel region in the gallium nitride substrate between the elongated source contact and the U-shaped drain contact, where the U-shaped drain contact has a closed end located in a peripheral ancillary region between the first source end and the output terminal; and
a U-shaped gate contact positioned over the U-shaped channel region and between the U-shaped drain contact and the elongated source contact, where the U-shaped gate contact has a closed end located in the peripheral ancillary region between the first source end and the output terminal.
